# EUROPÄISCHE PATENTSCHRIFT

(11) **EP 3 839 487 B1**
(45) Veröffentlichungstag und Bekanntmachung des Hinweises auf die Patenterteilung: **02.11.2022**
(21) Anmeldenummer: 20212610.8
(22) Anmeldetag: 09.12.2020
(51) Int. Cl.: G01N 21/952

(54) **PRÜFSYSTEM ZUM OPTISCHEN ÜBERPRÜFEN EINER ELEKTRISCHEN LEITUNG**
TEST SYSTEM FOR OPTICALLY CHECKING AN ELECTRICAL LINE
SYSTÈME DE VÉRIFICATION PERMETTANT LA VÉRIFICATION VISUELLE D'UNE CONDUITE ÉLECTRIQUE

(30) Priorität: 19.12.2019 DE 102019135129
(43) Veröffentlichungstag der Anmeldung: 23.06.2021
(73) Patentinhaber: Lisa Dräxlmaier GmbH, 84137 Vilsbiburg (DE)
(72) Erfinder: WEBERBECK, Linus, 84137 Vilsbiburg (DE); KAGERHUBER, Manuel, 84140 Gangkofen (DE)

(56) Entgegenhaltungen:
- EP-A1- 1 720 003
- US-A1- 2008 063 426
- US-A1- 2016 377 555

## Beschreibung

### Technisches Gebiet

Die vorliegende Erfindung betrifft ein Prüfsystem zum optischen Überprüfen einer elektrischen Leitung.

### Stand der Technik

Zur Qualitätsprüfung von elektrischen Leitungen ist es oftmals nötig, diese von verschiedenen Seiten zu inspizieren. Dafür können Prüfsysteme mit optischen Hilfsmitteln und Kameras verwendet werden. Eine Herausforderung bei der Anwendung eines derartigen Prüfsystems zum optischen Überprüfen einer elektrischen Leitung kann insbesondere darin bestehen, dass von den zu prüfenden elektrischen Leitungen immer wieder Schmutzpartikel, wie beispielsweise abgebrochene Schirmlitzen oder dergleichen, die optischen Hilfsmittel oder Kameras verschmutzen und dadurch die optische Überprüfung erschwert wird. Die US 2016/377 555 A1 offenbart ein Drahtprüfsystem. Die US 2008/063426 A1 offenbart ein Abbildungssystem. Die EP 1 720 003 A1 offenbart ein optisches System zur simultanen multidirektionalen Beobachtung.

### Beschreibung der Erfindung

Es ist daher die Aufgabe der Erfindung, eine Lösung bereitzustellen, mittels welcher auf besonders einfache Weise eine dauerhaft zuverlässige optische Überprüfung einer elektrischen Leitung erfolgen kann.

Diese Aufgabe wird durch ein Prüfsystem zum optischen Überprüfen einer elektrischen Leitung mit den Merkmalen des Anspruchs 1 gelöst. Weitere mögliche Ausgestaltungen der Erfindung sind insbesondere in den abhängigen Ansprüchen angegeben.

Das erfindungsgemäße Prüfsystem zum optischen Überprüfen einer elektrischen Leitung umfasst einen Prüfbereich zum Anordnen der elektrischen Leitung und mehrere den Prüfbereich umgebende Prismen. Des Weiteren weist das Prüfsystem eine auf die Prismen gerichtete Kamera auf, welche dazu ausgelegt ist, die im Prüfbereich angeordnete elektrische Leitung durch die Prismen von verschiedenen Seiten optisch zu erfassen. Zudem umfasst das Prüfsystem eine Abschirmvorrichtung, deren gekrümmte Innenkontur den Prüfbereich und die Prismen zumindest in radialer Richtung umschließt. Das Prüfsystem weist des Weiteren einen Luftkanal auf, der zumindest mittelbar an einer auf den Prüfbereich gerichteten Düse angeschlossen ist, die dazu ausgelegt ist, zumindest einige dem Prüfbereich zugewandte Prismenflächen mit einem Reinigungsluftstrom zu beaufschlagen und dadurch auf diesen Prismenflächen vorhandene Schmutzpartikel mitzureißen. Die Düse kann beispielsweise von oben auf den Prüfbereich gerichtet sein. Des Weiteren weist das Prüfsystem weitere in einen Bereich der Innenkontur der Abschirmvorrichtung mündende Luftkanäle auf, die dazu ausgelegt sind, die Innenkontur der Abschirmvorrichtung in zwei entgegengesetzte Umfangsrichtungen mit jeweiligen Mitnahmeluftströmen zu beaufschlagen, welche den Reinigungsluftstrom mitsamt den mitgerissenen Schmutzpartikeln in einen Luftauslass in einem unteren Bereich der Innenkontur der Abschirmvorrichtung lenken. Die weiteren Luftkanäle können beispielsweise in einen oberen Bereich der Innenkontur münden.

Statt die Schmutzpartikel von den Prismenflächen, welche dem Prüfbereich zugewandt sind, abzusaugen, ist es bei dem erfindungsgemäßen Prüfsystem also vorgesehen, die Prismenflächen durch Beaufschlagung mit dem Reinigungsluftstrom mitzureißen und somit zu entfernen. Insbesondere bei beengten Bauraumverhältnissen an der zu reinigenden Stelle kann es vorkommen, dass keine ausreichenden Luftführungen möglich sind, die mittels Unterdruck genug Luftstrom zulassen würden, um eine ausreichende Reinigungswirkung zu entfalten. Bei der erfindungsgemäßen Lösung ist es auch nicht nur vorgesehen, die verunreinigten Stellen, also die besagten Prismenflächen, einfach nur anzublasen beziehungsweise abzublasen. Denn dies könnte die weggerissenen Schmutzpartikel einfach nur an andere Stellen des Prüfsystems verbringen, infolgedessen andere optische Komponenten, wie beispielsweise die Kamera, verschmutzt werden könnten. Die Abschirmvorrichtung ist so gestaltet, dass sie den Prüfbereich und die Prismen nicht vollständig abschirmt, da dies ansonsten das Prüfsystem beispielsweise durch Reflexionen beeinträchtigen könnte.

Statt die mitgerissenen beziehungsweise aufgewirbelten Schmutzpartikel einfach nur abzusaugen, ist es bei dem erfindungsgemäßen Prüfsystem vorgesehen, die Innenkontur der Abschirmvorrichtung mit den besagten Mitnahmeluftströmen über die in den Bereich der Innenkontur der Abschirmvorrichtung mündenden Luftkanäle zu beaufschlagen, wodurch die Schmutzpartikel in Richtung des Luftauslasses im unteren Bereich der Innenkontur der Abschirmvorrichtung befördert werden. Würden die von den Prismenflächen entfernten beziehungsweise mitgerissenen Schmutzpartikel abgesaugt werden, wäre hingegen ein enormer Volumenstrom mit entsprechend großen Luftführungsquerschnitten und/oder eine Vielzahl von Saugstellen notwendig. Insbesondere letzteres wäre strömungstechnisch ungünstig. Auch ist es bei dem erfindungsgemäßen Prüfsystem nicht notwendig, einen Luftvorhang rund um die Absaugstelle, also rund um den Prüfbereich und die Prismen vorzusehen.

Über die besagte Düse ist es also möglich, zumindest einige der dem Prüfbereich zugewandte Prismenflächen mit dem Reinigungsluftstrom zu beaufschlagen und die Prismenflächen dadurch von vorhandenen Schmutzpartikeln zu befreien. Die dadurch mittels des Reinigungsluftstroms aufgenommenen beziehungsweise mitgerissenen Schmutzpartikel werden gemeinsam mit dem Reinigungsluftstrom durch die Mitnahmeluftströme zumindest im Wesentlichen vollständig der Innenkontur der Abschirmvorrichtung folgend mitgerissen, bis die Luftströme mitsamt den Schmutzpartikeln das Prüfsystem über besagten Luftauslass im unteren Bereich der Innenkontur der Abschirmvorrichtung verlassen.

Insbesondere ist es mittels des erfindungsgemäßen Prüfsystems auch möglich, die Reinigung des Prüfsystems zu automatisieren, und das, ohne eine nennenswerte Unterbrechung von Prüfzyklen vornehmen zu müssen. Das erfindungsgemäße Prüfsystem muss zur Reinigung der besagten Prismenflächen und/oder des Prüfbereichs nicht einmal geöffnet werden. Prüfungsunterbrechungen beziehungsweise Produktionsunterbrechungen sind bei dem erfindungsgemäßen Prüfsystem während der Reinigungsvorgänge also nicht notwendig.

Ansonsten bei einer manuellen Reinigung eventuell auftretende Beschädigungen oder Dejustierungen am Prüfsystem können zudem zuverlässig verhindert werden. Durch die Formgebung der gekrümmten Innenkontur der Abschirmvorrichtung und durch die Ausgestaltung der Luftkanäle ist es möglich, eine zumindest im Wesentlichen laminare Strömung der Mitnahmeluftströme entlang der Innenkontur der Abschirmvorrichtung zu realisieren. Durch die laminare Ausgestaltung der Mitnahmeluftströme ist es auf zuverlässige Weise möglich, die durch den Reinigungsluftstrom aufgewirbelten beziehungsweise entfernten Schmutzpartikel zuverlässig in Richtung des Luftauslasses im unteren Bereich der Innenkontur der Abschirmvorrichtung zu lenken. Aufgrund der laminaren Strömung können Verwirbelungen verhindert werden, aufgrund derer die entfernten beziehungsweise aufgewirbelten Schmutzpartikel die Abschirmvorrichtung ansonsten in Richtung des Inneren des Prüfsystems verlassen könnten.

Insgesamt wird mittels des erfindungsgemäßen Prüfsystems also eine besonders einfache und effektive Möglichkeit bereitgestellt, bei Bedarf das Prüfsystem, insbesondere die besagten Prismen, von Schmutzpartikeln zu befreien, und zwar ohne diese Schmutzpartikel in anderen Bereichen des Prüfsystems, wie beispielsweise an der Kamera abzulagern.

Eine mögliche Ausgestaltung der Erfindung sieht vor, dass die Innenkontur der Abschirmvorrichtung zumindest im Wesentlichen ringförmig ist. Dadurch lässt sich auf besonders zuverlässige Weise eine laminare Strömung bei den Mitnahmeluftströmen erzielen, sodass innerhalb der Mitnahmeluftströme keine oder so gut wie keine Verwirbelungen entstehen. Dies trägt dazu bei, die von den Prismenflächen mittels des Reinigungsluftstroms entfernten beziehungsweise aufgewirbelten Schmutzpartikel zuverlässig in Richtung des Luftauslasses im unteren Bereich der Innenkontur der Abschirmvorrichtung zu lenken.

Eine weitere mögliche Ausgestaltung der Erfindung sieht vor, dass die zum Zuführen der Mitnahmeluftströme ausgelegten Luftkanäle in tangentialer Richtung in die Innenkontur der Abschirmvorrichtung münden. Dadurch kann auf besonders zuverlässige Weise sichergestellt werden, dass die Mitnahmeluftströme in Umfangsrichtung entlang der Innenkontur der Abschirmvorrichtung strömen, sodass eine zumindest im Wesentlichen laminare Strömung bei den Mitnahmeluftströmen erzielt werden kann. Dies trägt ebenfalls dazu bei, innerhalb der Mitnahmeluftströme Verwirbelungen zu verhindern, infolgedessen die mittels des Reinigungsluftstroms mitgerissenen Schmutzpartikel besonders zuverlässig in Richtung des Luftauslasses im unteren Bereich der Innenkontur der Abschirmvorrichtung gelenkt werden können.

Gemäß einer weiteren möglichen Ausgestaltung der Erfindung ist es vorgesehen, dass die Innenkontur einen erhöhten Rand aufweist, um ein Austreten der Mitnahmeluftströme des Reinigungsluftstroms aus der Abschirmvorrichtung, außer durch den Luftauslass, zu verhindern. Insbesondere in Richtung der Kamera ist der Rand so hoch beziehungsweise so groß ausgebildet, dass die Kamera noch zuverlässig die im Prüfbereich angeordnete elektrische Leitung durch die Prismen von verschiedenen Seiten optisch erfassen kann. Unter Erfüllung dieser Voraussetzung ist der Rand so groß gestaltet, dass die Luftströme und insbesondere die mitgerissenen Schmutzpartikel nicht über den Rand hinaus die Abschirmvorrichtung verlassen können. Dadurch kann sichergestellt werden, dass die Schmutzpartikel nicht an unerwünschte Stellen des Prüfsystems gelangen.

Gemäß einer weiteren möglichen Ausgestaltung der Erfindung ist es vorgesehen, dass das Prüfsystem eine Fördereinrichtung aufweist, die dazu ausgelegt ist, bei den Mitnahmeluftströmen einen größeren Volumenstrom als beim Reinigungsluftstrom einzustellen. Bei der Fördereinrichtung ist es insbesondere möglich, die jeweiligen Volumenströme bei den Mitnahmeluftströmen und beim Reinigungsluftstrom so einzustellen, dass eine besonders gute Reinigungswirkung erzielt wird. Darunter ist insbesondere zu verstehen, dass einerseits die besagten Prismenflächen zuverlässig von den vorhandenen Schmutzpartikeln befreit werden, wobei andererseits sichergestellt werden kann, dass die Mitnahmeluftströme so stark und dabei dennoch so laminar ausgebildet sind, dass die aufgewirbelten beziehungsweise entfernten Schmutzpartikel zuverlässig in Richtung des Luftauslasses im unteren Bereich der Innenkontur der Abschirmvorrichtung gelenkt werden. Der Reinigungsluftstrom kann mittels der Fördereinrichtung dabei so eingestellt werden, dass auf den Prismen abgelagerte Schmutzpartikel relativ leicht weggeblasen beziehungsweise angeblasen werden, infolgedessen sie schwerkraftbedingt vor allem nach unten fallen, wo sie dann mittels der Mitnahmeluftströme in Richtung des Luftauslasses befördert werden.

Eine weitere mögliche Ausgestaltung der Erfindung sieht vor, dass das Prüfsystem dazu ausgelegt ist, die Mitnahmeluftströme und den Reinigungsluftstrom automatisch zur Reinigung der Prismen durch die Luftkanäle einzuleiten. So ist es ohne menschliches Zutun möglich, beispielsweise in festen Zeitabständen oder auch nach anderen Kriterien das Prüfsystem automatisch zu reinigen, also insbesondere die Prismen von etwaigen Schmutzpartikeln zu befreien. Falls das Prüfsystem in eine Produktionsanlage eingebunden ist, kann die automatische Reinigung der Prismen beispielsweise an einen Produktionstakt angepasst erfolgen, sodass keine Verzögerungen während der Produktion erfolgen.

Eine weitere mögliche Ausgestaltung der Erfindung sieht vor, dass das Prüfsystem eine Absaugeinrichtung aufweist, welche dazu ausgelegt ist, am Luftauslass einen Unterdruck anzulegen. Dadurch können die jeweiligen Luftströme mitsamt den mitgerissenen Schmutzpartikeln besonders zuverlässig durch den Luftauslass abgesaugt werden.

In weiterer möglicher Ausgestaltung der Erfindung ist es vorgesehen, dass der Luftkanal, der zumindest mittelbar an der auf den Prüfbereich gerichteten Düse angeschlossen ist, in denselben Bereich der Innenkontur der Abschirmvorrichtung mündet wie die Luftkanäle, die dazu ausgelegt sind, die Innenkontur der Abschirmvorrichtung in zwei entgegengesetzte Umfangsrichtungen mit den Mitnahmeluftströmen zu beaufschlagen. Anschlussstellen zum Zuführen der Mitnahmeluftströme und des Reinigungsluftstroms können also gesammelt im selben Bereich der Abschirmvorrichtung vorgesehen werden. Eine Anschlussstelle der Düse, an welcher der Luftkanal zumindest mittelbar angeschlossen ist, kann beispielsweise in der Nähe des Bereichs angeordnet sein, in den sämtliche Luftkanäle münden. Bei entsprechender Positionierung der Düse kann der Luftkanal, der an der Düse angeschlossen ist, also besonders nah an der Düse angeordnet sein, sodass besonders geringe Strömungsverluste vom Luftkanal bis zur Düse entstehen.

Schließlich sieht eine weitere mögliche Ausgestaltung der Erfindung vor, dass das Prüfsystem eine mittels einer Halterung aufgenommene Beleuchtungseinrichtung zum Beleuchten des Prüfbereichs aufweist, wobei die Düse in ein Bauteil der Halterung integriert ist. Mittels der Beleuchtungseinrichtung lässt sich der Prüfbereich und die zu überprüfende Leitung beleuchten, was die Überprüfung der betreffenden Leitung erleichtern kann. Dadurch, dass die Düse in ein Bauteil der Halterung integriert ist, kann die Düse besonders bauraumsparend und ohne zusätzliche Teile in das Prüfsystem integriert werden.

Weitere Vorteile, Merkmale und Einzelheiten der Erfindung können sich aus der nachfolgenden Beschreibung möglicher Ausführungsbeispiele sowie anhand der Zeichnung ergeben. Die vorstehend in der Beschreibung genannten Merkmale und Merkmalskombinationen sowie die nachfolgend in der Figurenbeschreibung und/oder in den Figuren alleine gezeigten Merkmale und Merkmalskombinationen sind nicht nur in der jeweils angegebenen Kombination, sondern auch in anderen Kombinationen oder in Alleinstellung verwendbar, ohne den Rahmen der Erfindung zu verlassen.

### Kurze Figurenbeschreibung

Die Zeichnung zeigt in:
- Fig. 1: eine Perspektivansicht eines Prüfsystems zum optischen Überprüfen einer elektrischen Leitung;
- Fig. 2: eine Rückansicht auf das teilweise dargestellte Prüfsystem, wobei ein Prüfbereich zum Anordnen der elektrischen Leitung sowie mehrere den Prüfbereich umgebende Prismen zu sehen sind;
- Fig. 3: eine Frontalansicht auf ein Teil des Prüfsystems, wobei die Anordnung der Prismen zu erkennen ist;
- Fig. 4: eine geschnittene Seitenansicht des Prüfsystems im Bereich der Prismen, wobei eine Düse zu erkennen ist, die von schräg oben auf den Prüfbereich und die Prismen gerichtet ist;
- Fig. 5: eine Perspektivansicht auf eine im Wesentlichen ringförmige Abschirmvorrichtung, deren gekrümmte Innenkontur den Prüfbereich und die Prismen umschließt, wobei unterschiedliche Luftströme schematisch angedeutet sind;
- Fig. 6: eine Perspektivansicht einer weiteren möglichen Ausführungsform der Abschirmvorrichtung;
- Fig. 7: eine teilweise geschnittene Darstellung der weiteren möglichen Ausführungsformen der Abschirmvorrichtung;
- Fig. 8: eine teilweise geschnittene Detailansicht der weiteren möglichen Ausführungsformen der Abschirmvorrichtung, wobei unterschiedliche Luftkanäle zur Zuführung von Luft ins Innere der Abschirmvorrichtung dargestellt sind.

In den Figuren sind gleiche oder funktionsgleiche Elemente mit den gleichen Bezugszeichen versehen.

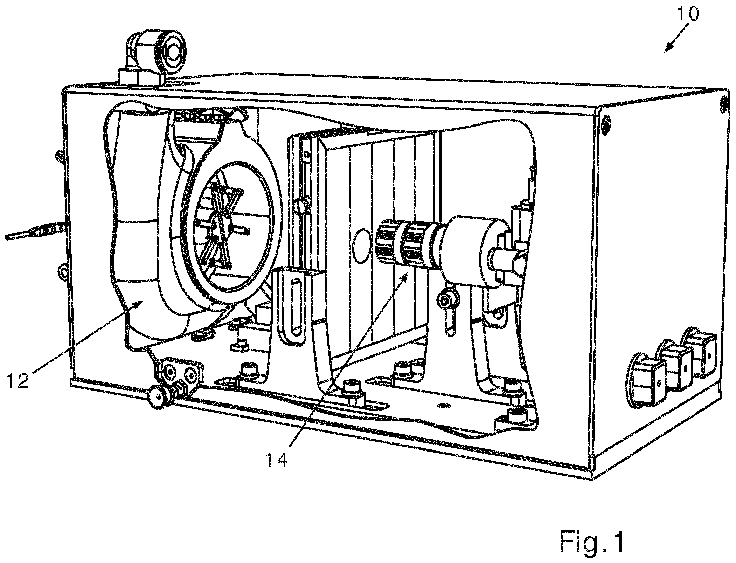

Ein Prüfsystem 10 zum optischen Überprüfen einer elektrischen Leitung ist in einer Perspektivansicht in Fig. 1 gezeigt. Im Inneren des Prüfsystems 10 angeordnete Teile sind durch eine Art Box beziehungsweise Gehäuse umschlossen, wobei in der vorliegenden Darstellung ein Teil einer Seitenwand der Box beziehungsweise des Gehäuses ausgespart ist, sodass der Blick ins Innere des Prüfsystems 10 freigegeben wird. Das Prüfsystem 10 umfasst eine im Wesentlichen ringförmige Abschirmvorrichtung 12, die einen hier nicht näher gekennzeichneten Prüfbereich und hier nicht erkennbare Prismen vor allem in radialer Richtung umschließt. Das Prüfsystem 10 umfasst unter anderem eine auf die hier nicht erkennbaren Prismen gerichtete Kamera 14, die dazu ausgelegt ist, die im Prüfbereich angeordnete elektrische Leitung durch die Prismen von verschiedenen Seiten optisch zu erfassen.

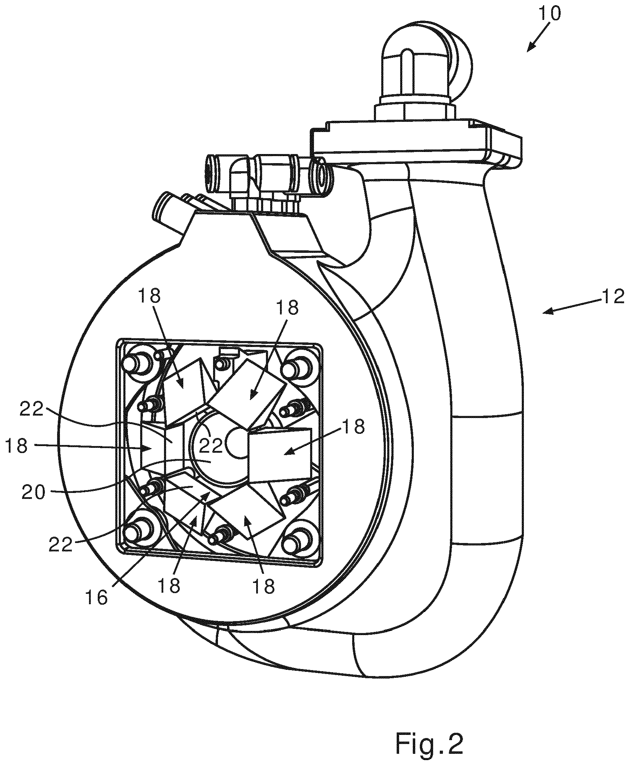

In Fig. 2 ist das Prüfsystem 10 teilweise in einer perspektivischen Rückansicht gezeigt. Durch Weglassen einiger Teile der Prüfsystems 10 ist der bereits erwähnte Prüfbereich 16 zu erkennen, in dem die elektrische Leitung zur optischen Überprüfung angeordnet werden kann. Vorliegend sind die auch zuvor schon erwähnten Prismen 18 zu erkennen, welche den Prüfbereich 16 umgeben. Des Weiteren ist noch eine Beleuchtungseinrichtung 20 zu erkennen, welche dazu dient, den Prüfbereich 16 und die darin angeordnete hier nicht dargestellte elektrische Leitung zu beleuchten. Jeweilige Prismenflächen 22 sind dabei ringförmig um den Prüfbereich 16 angeordnet und auf diesen gerichtet.

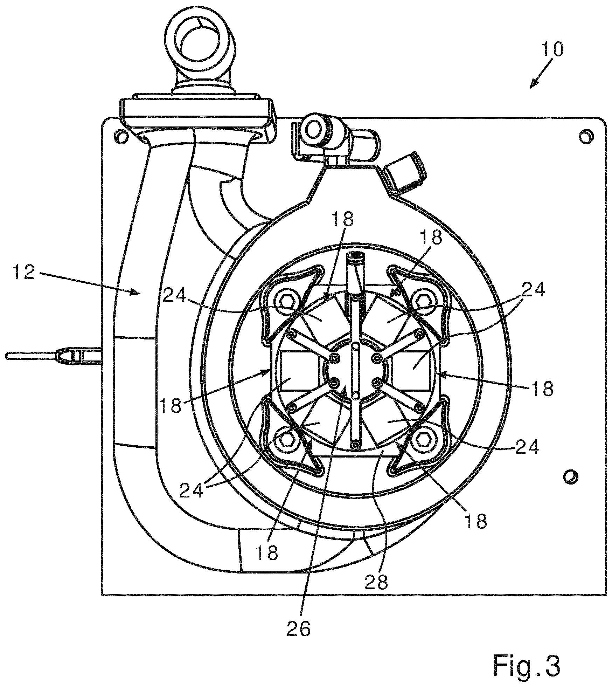

In Fig. 3 ist das Prüfsystem 10 teilweise in einer Frontalansicht gezeigt, wobei der Blick auf die Prismen 18 freigegeben ist. Die im Zusammenhang mit Fig. 1 erwähnte Kamera 14 blickt aus der hier gezeigten Perspektive auf jeweilige Vorderseiten 24 der Prismen 18. Dadurch kann die Kamera 14 die im Prüfbereich 16 angeordnete elektrische Leitung durch die Prismen 18 von verschiedenen Seiten optisch erfassen. Über die Prismenflächen 22 (siehe Fig. 2) werden Lichtstrahlen zu den Vorderseiten 24 der Prismen 18 gelenkt, sodass die Kamera 14 die im Prüfbereich 16 angeordnete elektrische Leitung von verschiedenen Seiten optisch erfassen kann.

Bei der Anordnung und Überprüfung der elektrischen Leitung kann es passieren, dass verschiedenste Schmutzpartikel sich auf den Prismenflächen 22 (siehe Fig. 2) ablagern, insbesondere auf denjenigen Prismenflächen 22 der unten angeordneten Prismen 18. Es können beispielsweise abgebrochene Schirmlitzen, Staub oder auch andere Schmutzpartikel insbesondere auf die unteren Prismenflächen 22 gelangen. Dies kann die optische Überprüfung der elektrischen Leitung erschweren. In der vorliegenden Darstellung ist zudem noch eine Halterung 26 zu erkennen, mittels welcher die in Fig. 2 gezeigte Beleuchtungseinrichtung 20 gehalten ist. Des Weiteren ist noch ein Prismenträger 28 zu erkennen, der dazu dient die einzelnen Prismen 18 aufzunehmen und zu halten.

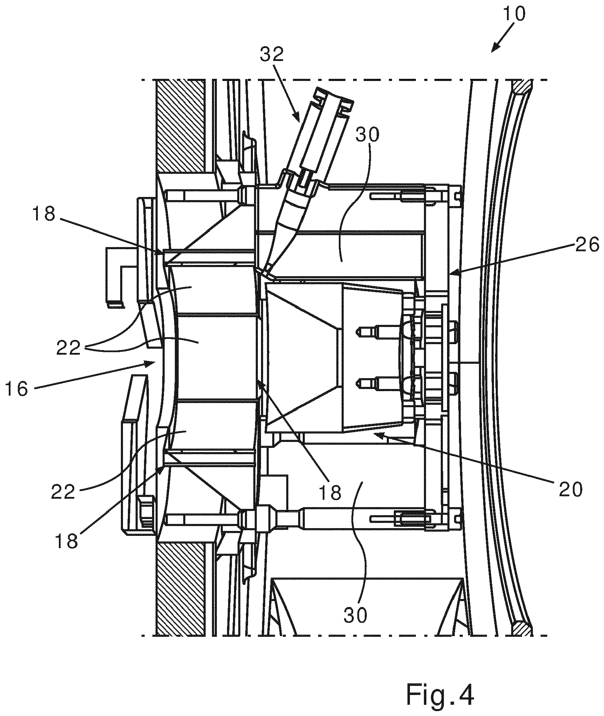

In Fig. 4 ist das Prüfsystem 10 in einer teilweise geschnittenen Seitenansicht im Bereich des Prüfbereichs 16 und der Prismen 18 sowie der Beleuchtungseinrichtung 20 gezeigt. Vorliegend sind einige Bauteile 30 zu erkennen, welche Bestandteil der Halterung 26 sind und dazu dienen, die Beleuchtungseinrichtung 20 halten. Eine Düse 32 ist dabei in eines der Bauteile 30 der Halterung 26 integriert. Die Düse 32 ist von schräg oben auf die unteren Prismen 18 gerichtet. Die Düse 32 dient dazu, insbesondere die Prismenflächen 22 der unten angeordneten Prismen 18 von Schmutzpartikeln zu befreien. Eine wesentliche Herausforderung beim Wegblasen solcher Schmutzpartikel liegt darin, dass diese Schmutzpartikel nicht an unerwünschte andere Stellen des Prüfsystems 10 gelangen, und so beispielsweise ein Objektiv der Kamera 14 zusetzen oder andere optische Elemente oder weitere Bauteile des Prüfsystems 10 beeinträchtigen.

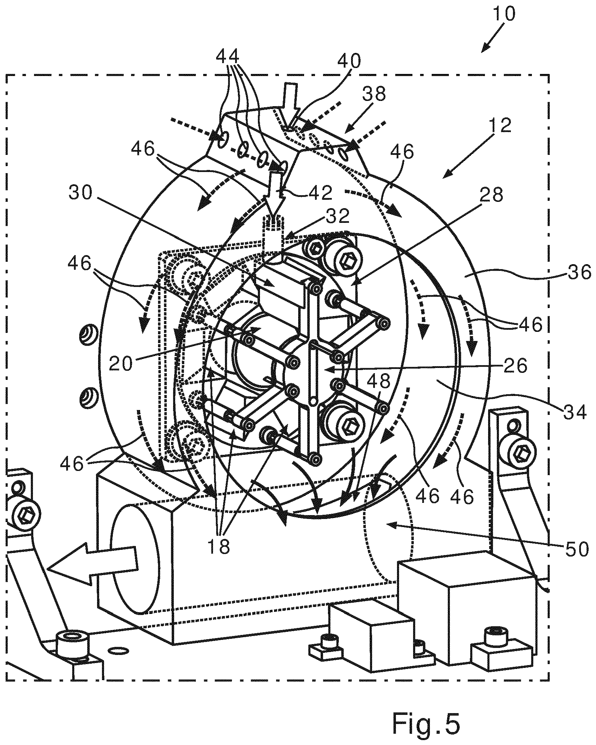

In Fig. 5 ist das Prüfsystems 10 teilweise in einer Perspektivansicht gezeigt, wobei insbesondere die im Wesentlichen ringförmige Abschirmvorrichtung 12 zu erkennen ist, welche die Prismen 18 und den hier nicht näher erkennbaren Prüfbereich 16 umgibt. Eine gekrümmte Innenkontur 34 der Abschirmvorrichtung 12 umgibt dabei den Prüfbereich 16 und die Prismen 18 ringförmig. Zudem weist die Abschirmvorrichtung 12 einen erhöhten Rand 36 auf. Der erhöhte Rand 36 umgibt eine hier nicht näher bezeichnete Öffnung, durch welche die Kamera 14 in der bereits beschriebenen Weise auf die Prismen 18 blicken und somit die elektrische Leitung von verschiedensten Seiten optisch erfassen kann.

In einem oberen Bereich 38 der Abschirmvorrichtung 12 ist ein Luftkanal 40 vorgesehen, welcher sich zumindest im Wesentlichen in vertikaler Richtung erstreckt und zumindest mittelbar an der von oben auf den Prüfbereich 16 gerichteten Düse 32 angeschlossen ist, die dazu ausgelegt ist, insbesondere die unterhalb vom Prüfbereich 16 angeordneten Prismenflächen 22 mit einem durch die Pfeile 42 schematisch angedeuteten Reinigungsluftstrom zu beaufschlagen und dadurch auf diesen Prismenflächen 22 vorhandene Schmutzpartikel mitzureißen.

Im oberen Bereich 38 der Abschirmvorrichtung 12 sind an gegenüberliegenden Seiten mehrere weitere Luftkanäle 44 vorgesehen, die zumindest im Wesentlichen tangential in die Innenkontur 34 der Abschirmvorrichtung 12 münden. Die Luftkanäle 44 sind dazu ausgelegt, die Innenkontur 34 der Abschirmvorrichtung 12 in zwei entgegengesetzte Umfangsrichtungen mit jeweiligen mittels der Pfeile 46 schematisch angedeuteten Mitnahmeluftströmen zu beaufschlagen.

Werden also die Prismenflächen 22 (siehe Fig. 2 und Fig. 4) mittels der Düse 32 mit dem Reinigungsluftstrom 42 beaufschlagt, werden insbesondere auf den unteren Prismenflächen 22 vorhandene Schmutzpartikel entfernt beziehungsweise mittels des Reinigungsluftstroms 42 mitgerissen. Schwerkraftbedingt und strömungsbedingt gelangen die mitgerissenen Schmutzpartikel gemeinsam mit dem Reinigungsluftstrom 42 vor allem nach unten, können aber auch seitlich in Richtung der Innenkontur 34 der Abschirmvorrichtung 12 abgelenkt werden. Die Mitnahmeluftströme 46 sind so stark und vor allem auch laminar ausgebildet, dass sie den Reinigungsluftstrom 42 mitsamt den mitgerissenen Schmutzpartikeln in einen Luftauslass 48 in einem unteren Bereich 50 der Innenkontur 34 der Abschirmvorrichtung 12 lenken. Durch den erhöhten Rand 36 wird ein Austreten der Mitnahmeluftströme 46 und des Reinigungsluftstroms 42 mitsamt der mitgerissenen Schmutzpartikel aus der Abschirmvorrichtung 12, außer durch den Luftauslass 48, weitestgehend verhindert.

Das Prüfsystem 10 kann eine Fördereinrichtung aufweisen, die dazu ausgelegt ist, bei den Mitnahmeluftströmen 46 einen größeren Volumenstrom als beim Reinigungsluftstrom 42 einzustellen. Mittels des Reinigungsluftstroms 42 können also Schmutzpartikel relativ sanft von den jeweiligen Prismenflächen 22 weggeblasen werden, ohne dass dadurch allzu große Verwirbelungen entstehen und die Schmutzpartikel sich nicht zu stark verteilen und insbesondere dabei schon die Abschirmvorrichtung 12 in unerwünschte Richtungen verlassen. Die Mitnahmeluftströme 46 werden hinsichtlich ihres Volumenstroms so eingestellt, dass sie eine laminare Strömung entlang der Innenkontur 34 ausbilden und stark genug sind, die aufgewirbelten beziehungsweise mittels des Reinigungsluftstroms 42 mitgerissenen Schmutzpartikel in Richtung des Luftauslasses 48 zu lenken, durch welchen dann die jeweiligen Luftströme 42, 46 und die Schmutzpartikel die Abschirmvorrichtung 12 und letztlich somit auch das Prüfsystem 10 verlassen. Insbesondere kann das Prüfsystem 10 auch dazu ausgelegt sein, die Mitnahmeluftströme 46 und den Reinigungsluftstrom 42 automatisch zur Reinigung der Prismen 18 durch die jeweiligen Luftkanäle 40, 44 einzuleiten. Das Prüfsystem 10 kann zudem eine hier nicht dargestellte Absaugvorrichtung aufweisen, welche dazu ausgelegt ist, am Luftauslass 48 einen Unterdruck anzulegen.

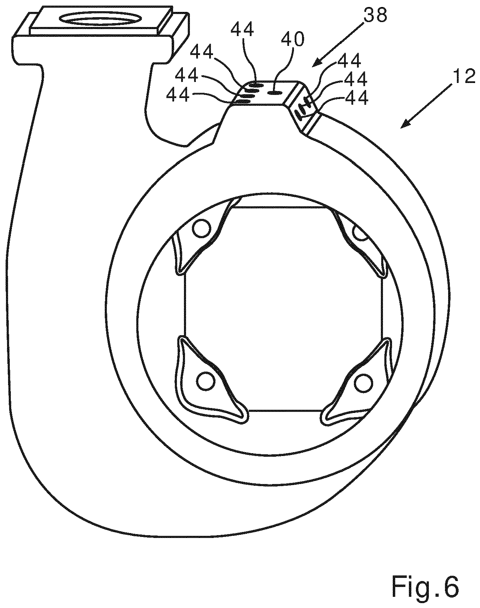

In Fig. 6 ist eine weitere mögliche Ausgestaltung der Abschirmvorrichtung 12 in einer Perspektivansicht gezeigt. Vorliegend sind wiederum die Luftkanäle 44 zu erkennen, welche dazu dienen, die hier nicht dargestellten Mitnahmeluftströme 46 zur Innenkontur 34 der Abschirmvorrichtung 12 zu leiten. Des Weiteren ist noch der Luftkanal 40 zu erkennen, welcher sich im Wesentlichen in vertikaler Richtung nach unten erstreckt und zumindest mittelbar mit der hier nicht dargestellten Düse 32 verbunden sein kann. Die Luftkanäle 40, 44 sind wiederum im oberen Bereich 38 der Abschirmvorrichtung 12 angeordnet. Eine Umlenkung des Ausstroms der jeweiligen Luftströme 42, 46 kann, wie hier gezeigt, beispielsweise bauraumbedingt nach oben erfolgen, kann aber auch in andere Richtungen erfolgen.

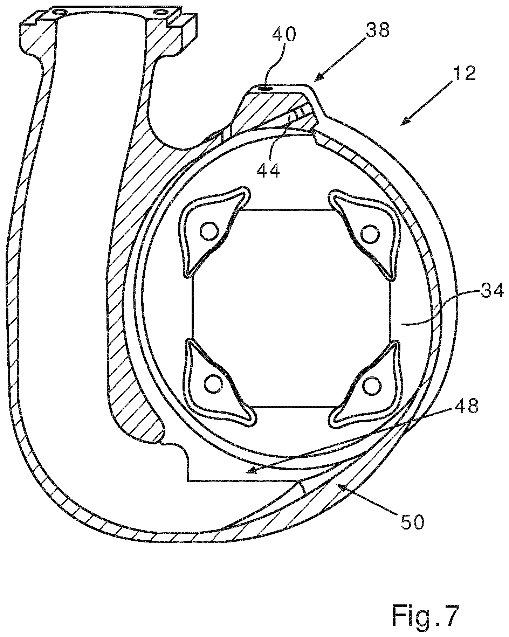

In Fig. 7 ist die weitere mögliche Ausführungsform der Abschirmvorrichtung 12 in einer teilweise geschnittenen Ansicht gezeigt. Vorliegend kann man nochmals gut die im Wesentlichen kreisförmige Ausgestaltung der Innenkontur 34 erkennen. Zudem ist im oberen Bereich 38 einer der Luftkanäle 44 zu erkennen, welcher dazu dient, die hier nicht gekennzeichneten Mitnahmeluftströme 46 zumindest im Wesentlichen in tangentialer Richtung zur Innenkontur 34 einzuleiten. Die jeweiligen Luftkanäle 44 sind also so schräg angestellt angeordnet, dass die jeweiligen Mitnahmeluftströme 46 tangential der Krümmung der Innenkontur 34 folgend eingeleitet werden. Dadurch können die Mitnahmeluftströme 46 als laminare Strömungen ausgebildet werden, sodass innerhalb der Mitnahmeluftströme 46 keine Verwirbelungen entstehen und mittels der Mitnahmeluftströme 46 die aufgewirbelten beziehungsweise abgelösten Schmutzpartikel zuverlässig in Richtung des Luftauslasses 48 im unteren Bereich der Innenkontur 34 gelenkt werden können.

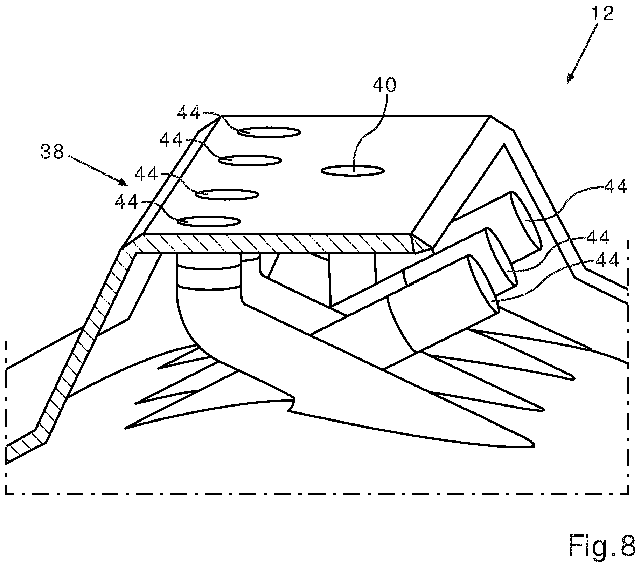

In Fig. 8 ist die weitere mögliche Ausführungsform der Abschirmvorrichtung 12 in einer Detailansicht gezeigt. Vorliegend kann man die Anordnung und den Verlauf der jeweiligen Luftkanäle 40, 44 im oberen Bereich 38 der Abschirmvorrichtung 12 nochmals gut erkennen. Hier sieht man nochmals deutlich, dass der Luftkanal 40, welcher zur Zuführung des Reinigungsluftstroms 42 dient, sich zumindest im Wesentlichen in vertikaler Richtung erstreckt, wobei die zum Zuführen der Mitnahmeluftströme 46 dienenden Luftkanäle 44 so schräg verlaufen, dass die Mitnahmeluftströme 46 laminar entlang der Innenkontur 34 der Abschirmvorrichtung 12 strömen.

### BEZUGSZEICHENLISTE

- 10: Prüfsystem
- 12: Abschirmvorrichtung
- 14: Kamera
- 16: Prüfbereich
- 18: Prismen
- 20: Beleuchtungseinrichtung
- 22: Prismenflächen
- 24: Vorderseiten der Prismen
- 26: Halterung der Beleuchtungseinrichtung
- 28: Prismenträger
- 30: Bauteile der Halterung
- 32: Düse
- 34: Innenkontur der Abschirmvorrichtung
- 36: erhöhter Rand der Innenkontur
- 38: oberer Bereich der Innenkontur der Abschirmvorrichtung
- 40: zumindest mittelbar an der Düse angeschlossener Luftkanal
- 42: Reinigungsluftstrom
- 44: Luftkanäle zum Zuführen der Mitnahmeluftströme
- 46: Mitnahmeluftströme
- 48: Luftauslass im unteren Bereich der Innenkontur der Abschirmvorrichtung
- 50: unterer Bereich der Innenkontur der Abschirmvorrichtung

## Patentansprüche

1. Prüfsystem (10) zum optischen Überprüfen einer elektrischen Leitung, umfassend
- einen Prüfbereich (16) zum Anordnen der elektrischen Leitung;
- mehrere den Prüfbereich (16) umgebende Prismen (18);
- eine auf die Prismen (18) gerichtete Kamera (14), welche dazu ausgelegt ist, die im Prüfbereich (16) angeordnete elektrische Leitung durch die Prismen (18) von verschiedenen Seiten optisch zu erfassen;
- eine Abschirmvorrichtung (12), deren gekrümmte Innenkontur (34) den Prüfbereich (16) und die Prismen (18) zumindest in radialer Richtung umschließt;
- einen Luftkanal (40), der zumindest mittelbar an einer auf den Prüfbereich (16) gerichteten Düse (32) angeschlossen ist, die dazu ausgelegt ist, zumindest einige dem Prüfbereich (16) zugewandte Prismenflächen (22) mit einem Reinigungsluftstrom (42) zu beaufschlagen und dadurch auf diesen Prismenflächen (22) vorhandene Schmutzpartikel mitzureißen;
- weitere in einen Bereich (38) der Innenkontur (34) der Abschirmvorrichtung (12) mündende Luftkanäle (44), die dazu ausgelegt sind, die Innenkontur (38) der Abschirmvorrichtung (12) in zwei entgegengesetzte Umfangsrichtungen mit jeweiligen Mitnahmeluftströmen (46) zu beaufschlagen, welche den Reinigungsluftstrom (42) mitsamt den mitgerissenen Schmutzpartikeln in einen Luftauslass (48) in einem unteren Bereich (50) der Innenkontur (34) der Abschirmvorrichtung (12) lenken.

2. Prüfsystem (10) nach Anspruch 1,
**dadurch gekennzeichnet, dass**
die Innenkontur (34) der Abschirmvorrichtung (12) zumindest im Wesentlichen ringförmig ist.

3. Prüfsystem (10) nach Anspruch 1 oder 2,
**dadurch gekennzeichnet, dass**
die zum Zuführen der Mitnahmeluftströme (46) ausgelegten Luftkanäle (44) in tangentialer Richtung in die Innenkontur (34) der Abschirmvorrichtung (12) münden.

4. Prüfsystem (10) nach einem der vorhergehenden Ansprüche,
**dadurch gekennzeichnet, dass**
die Innenkontur (34) einen erhöhten Rand (36) aufweist, um ein Austreten der Mitnahmeluftströme (46) und des Reinigungsluftstroms (42) aus der Abschirmvorrichtung (12), außer durch den Luftauslass (48), zu verhindern.

5. Prüfsystem (10) nach einem der vorhergehenden Ansprüche,
**dadurch gekennzeichnet, dass**
das Prüfsystem (10) eine Fördereinrichtung aufweist, die dazu ausgelegt ist, bei den Mitnahmeluftströmen (46) einen größeren Volumenstrom als beim Reinigungsluftstrom (42) einzustellen.

6. Prüfsystem (10) nach einem der vorhergehenden Ansprüche,
**dadurch gekennzeichnet, dass**
das Prüfsystem (10) dazu ausgelegt ist, die Mitnahmeluftströme (46) und den Reinigungsluftstrom (42) automatisch zur Reinigung der Prismen (18) durch die Luftkanäle (40, 44) einzuleiten.

7. Prüfsystem (10) nach einem der vorhergehenden Ansprüche,
**dadurch gekennzeichnet, dass**
das Prüfsystem (10) eine Absaugeinrichtung aufweist, welche dazu ausgelegt ist, am Luftauslass (48) einen Unterdruck anzulegen.

8. Prüfsystem (10) nach einem der vorhergehenden Ansprüche,
**dadurch gekennzeichnet, dass**
der Luftkanal (40), der zumindest mittelbar an der auf den Prüfbereich (16) gerichteten Düse (32) angeschlossen ist, in denselben Bereich (38) der Innenkontur (34) der Abschirmvorrichtung (12) mündet, wie die Luftkanäle (44), die dazu ausgelegt sind, die Innenkontur (38) der Abschirmvorrichtung (12) in zwei entgegengesetzte Umfangsrichtungen mit den Mitnahmeluftströmen (46) zu beaufschlagen.

9. Prüfsystem (10) nach einem der vorhergehenden Ansprüche,
**dadurch gekennzeichnet, dass**
das Prüfsystem (10) eine mittels einer Halterung (26) aufgenommene Beleuchtungseinrichtung (20) zum Beleuchten des Prüfbereichs (16) aufweist, wobei die Düse (32) in ein Bauteil (30) der Halterung (26) integriert ist.

## Claims

1. Test system (10) for optically checking an electrical line, comprising:
- a test area (16) for arranging the electrical line;
- a plurality of prisms (18) surrounding the test area (16);
- a camera (14), which is directed at the prisms (18) and is designed to optically detect the electrical line arranged in the test area (16) through the prisms (18) from different sides;
- a shielding device (12), the curved inner contour (34) of which encloses the test area (16) and the prisms (18) at least in a radial direction;
- an air duct (40), which is at least indirectly connected to a nozzle (32) which is directed towards the test area (16) and is designed to subject at least some prism surfaces (22) facing the test region (16) to a cleaning air stream (42) and thereby entrain dirt particles present on these prism surfaces (22);
- further air ducts (44), which open into an area (38) of the inner contour (34) of the shielding device (12) and are designed to subject the inner contour (38) of the shielding device (12) to respective entraining air streams (46) in two opposite circumferential directions, which direct the cleaning air stream (42) together with the entrained dirt particles into an air outlet (48) in a lower region (50) of the inner contour (34) of the shielding device (12).

2. Test system (10) according to Claim 1, **characterized in that**
the inner contour (34) of the shielding device (12) is at least substantially annular.

3. Test system (10) according to Claim 1 or 2, **characterized in that**
the air ducts (44) designed to supply the entraining air streams (46) open in a tangential direction into the inner contour (34) of the shielding device (12).

4. Test system (10) according to one of the preceding claims,
**characterized in that**
the inner contour (34) has a raised edge (36), in order to prevent the entraining air streams (46) and the cleaning air stream (42) from leaving the shielding device (12) except through the air outlet (48) .

5. Test system (10) according to one of the preceding claims,
**characterized in that**
the test system (10) has a conveying device, which is designed to set a greater volumetric flow for the entraining air streams (46) than for the cleaning air stream (42).

6. Test system (10) according to one of the preceding claims,
**characterized in that**
the test system (10) is designed to automatically introduce the entraining air streams (46) and the cleaning air stream (42) for cleaning the prisms (18) through the air ducts (40, 44).

7. Test system (10) according to one of the preceding claims,
**characterized in that**
the test system (10) has a suction device, which is designed to apply a negative pressure at the air outlet (48).

8. Test system (10) according to one of the preceding claims,
**characterized in that**
the air duct (40), which is at least indirectly connected to the nozzle (32) directed towards the test area (16), opens into the same area (38) of the inner contour (34) of the shielding device (12) as the air ducts (44), which are designed to subject the inner contour (38) of the shielding device (12) to the entraining air streams (46) in two opposite circumferential directions.

9. Test system (10) according to one of the preceding claims,
**characterized in that**
the test system (10) has an illuminating device (20), held by means of a mount (26), for illuminating the test area (16), the nozzle (32) being integrated in a component (30) of the mount (26).

## Revendications

1. Système de contrôle (10) destiné au contrôle optique d'une ligne électrique, comprenant
- une zone de contrôle (16) servant à disposer la ligne électrique ;
- plusieurs prismes (18) qui entourent la zone de contrôle (16) ;
- une caméra (14) orientée sur les prismes (18), laquelle est conçue pour détecter optiquement la ligne électrique qui est disposée dans la zone de contrôle (16) depuis différents côtés à travers les prismes (18) ;
- un arrangement faisant écran (12), dont le contour intérieur (34) curviligne entoure la zone de contrôle (16) et les prismes (18) au moins dans la direction radiale ;
- un canal à air (40), qui est raccordé au moins indirectement à une buse (32) orientée sur la zone de contrôle (16) et qui est conçu pour charger au moins certaines des surfaces de prisme (22) faisant face à la zone de contrôle (16) avec un flux d'air de nettoyage (42) et ainsi d'emporter avec lui les particules de salissure présentes sur ces surfaces de prisme (22) ;
- des canaux à air (44) supplémentaires, qui débouchent dans une zone (38) du contour intérieur (34) de l'arrangement faisant écran (12), lesquels sont conçus pour charger le contour intérieur (38) de l'arrangement faisant écran (12) dans deux directions circonférentielles opposées respectivement de flux d'air d'entraînement (46), lesquels guident le flux d'air de nettoyage (42) avec les particules de salissure emportées dans une sortie d'air (48) dans une zone inférieure (50) du contour intérieur (34) de l'arrangement faisant écran (12) .

2. Système de contrôle (10) selon la revendication 1, **caractérisé en ce que** le contour intérieur (34) de l'arrangement faisant écran (12) est au moins sensiblement de forme annulaire.

3. Système de contrôle (10) selon la revendication 1 ou 2, **caractérisé en ce que** les canaux à air (44) conçus pour acheminer les flux d'air d'entraînement (46) débouchent dans la direction tangentielle dans le contour intérieur (34) de l'arrangement faisant écran (12).

4. Système de contrôle (10) selon l'une des revendications précédentes, **caractérisé en ce que** le contour intérieur (34) possède un bord rehaussé (36) afin d'éviter une sortie des flux d'air d'entraînement (46) et du flux d'air de nettoyage (42) hors de l'arrangement faisant écran (12) autrement que par la sortie d'air (48).

5. Système de contrôle (10) selon l'une des revendications précédentes, **caractérisé en ce que** le système de contrôle (10) possède un dispositif de transport qui est conçu pour régler un débit volumique plus élevé pour les flux d'air d'entraînement (46) que pour le flux d'air de nettoyage (42).

6. Système de contrôle (10) selon l'une des revendications précédentes, **caractérisé en ce que** le système de contrôle (10) est conçu pour faire passer les flux d'air d'entraînement (46) et le flux d'air de nettoyage (42) automatiquement à travers les canaux à air (40, 44) en vue du nettoyage des prismes (18).

7. Système de contrôle (10) selon l'une des revendications précédentes, **caractérisé en ce que** le système de contrôle (10) possède un dispositif d'aspiration, lequel est conçu pour appliquer une dépression au niveau de la sortie d'air (48).

8. Système de contrôle (10) selon l'une des revendications précédentes, **caractérisé en ce que** le canal à air (40), qui est raccordé au moins indirectement à la buse (32) orientée sur la zone de contrôle (16), débouche dans la même zone (38) du contour intérieur (34) de l'arrangement faisant écran (12) que les canaux à air (44), lesquels sont conçus pour charger le contour intérieur (38) de l'arrangement faisant écran (12) avec les flux d'air d'entraînement (46) dans deux directions circonférentielles opposées.

9. Système de contrôle (10) selon l'une des revendications précédentes, **caractérisé en ce que** le système de contrôle (10) possède un dispositif d'éclairage (20) accueilli dans le système de contrôle (10) au moyen d'un support (26) servant à éclairer la zone de contrôle (16), la buse (32) étant intégrée dans un élément structural (30) du support (26).
